# EUROPÄISCHE PATENTSCHRIFT

(11) **EP 4 062 231 B1**
(45) Veröffentlichungstag und Bekanntmachung des Hinweises auf die Patenterteilung: **24.01.2024**
(21) Anmeldenummer: 19809023.5
(22) Anmeldetag: 19.11.2019
(51) Int. Cl.: G03F 7/00

(54) **VORRICHTUNG UND VERFAHREN ZUM PRÄGEN VON MIKRO- UND/ODER NANOSTRUKTUREN**
APPARATUS AND METHOD FOR PATTERNING MICRO- AND/OR NANO-STRUCTURES
APPAREIL ET PROCÉDÉ DE FORMATION DE MOTIFS DE MICROSTRUCTURES ET/OU DE NANOSTRUCTURES

(43) Veröffentlichungstag der Anmeldung: 28.09.2022
(60) Teilanmeldung: 23210236.8
(73) Patentinhaber: EV Group E. Thallner GmbH, 4782 St. Florian am Inn (AT)
(72) Erfinder: KHAN, Jonas, 94036 Passau (DE); ZORBACH, Walter, 4792 Münzkirchen (AT)
(74) Vertreter: Schneider, Sascha
(86) Internationale Anmeldenummer: PCT/EP2019/081853
(87) Internationale Veröffentlichungsnummer: WO 2021/098953

(56) Entgegenhaltungen:
- WO-A1-2018/011208
- WO-A1-2019/145418
- US-A1- 2014 252 679

## Beschreibung

Die Erfindung betrifft eine Vorrichtung und ein Verfahren zum Prägen von Mikro- und/oder Nanostrukturen gemäß den nebengeordneten Ansprüchen.

Im Stand der Technik werden Mikro- und/oder Nanostrukturen entweder photolithographisch und/oder mit Hilfe der Imprintlithographie hergestellt. Unter der Imprintlithographie versteht man ein Verfahren, bei dem mikro-und/oder nanometergroße Strukturen durch einen Stempel in ein Material geprägt werden. Bei dem Material handelt es sich um ein auf ein Substrat aufgebrachtes Prägematerial. Derartige Imprintverfahren haben in den letzten Jahren zunehmend an Bedeutung gewonnen, da sie schneller, effektiver und kostengünstiger durchzuführen sind als viele photolithographischen Verfahren. Des Weiteren hat sich gezeigt, dass die erreichbare Auflösung mittels imprintlithographischer Verfahren der Auflösung, die man mit Hilfe der Photolithographie erzielen kann, um nichts nachsteht. In einigen Fällen wie im sog. "first print" kann imprintlithographisch bessere Auflösung erreicht werden, als mit herkömmlicher Lithographie.

WO2018011208A1 offenbart eine Vorrichtung zur Texturierung oder Musterung diskreter Substrate durch Aufdrucken eines härtbaren Lacks mit einem flexiblen Stempel. US2014252679A1 offenbart eine großformatige Druckvorrichtung mit einer Rolle-zu-Rolle-Einheit, die zum Auf- oder Abwickeln eines flexiblen Substrats konfiguriert ist. WO2019145418A1 offenbart ein Verfahren zur Texturierung eines diskreten Substrats mit einer Aufdrucktextur.

Die meisten Ausführungsformen der bekannten Vorrichtungen werden in sogenannte Maskenausrichter (engl.: Mask Aligner) eingebaut oder als eigenständige Anlage konzipiert, die aber keine Substrate größer als 300 mm prozessieren können. Aligner eignen sich besonders für spezielle Imprintanlagen, da sie in der Halbleiterindustrie bereits weite Verbreitung für die Photolithographie erfahren haben. Dadurch wurde es für Anbieter zweckmäßig, Erweiterungen und Aufsätze anzubieten, die auf bereits bekannter Mask Aligner Technologie aufbauten oder diese erweitern konnten. Der Vorteil von Mask Alignern besteht vor allem darin, dass sie in den meisten Fällen bereits über optische Systeme, insbesondere Lampenhäuser zur, insbesondere vollflächigen, Beleuchtung der Substrate und damit der geprägten Prägematerialien bieten.

Neben modifizierten bzw. erweiterten Mask Alignern existieren auch eigene Imprintanlagen, die auf und für spezielle Ausführungsformen gebaut wurden. Diese Anlagen sind meistens Ausrichtungsanlagen, die einen Stempel mit hoher Präzision zum Substrat ausrichten können. Des Weiteren verfügen diese Anlagen über die Möglichkeit zur Erzeugung von Vakuum, spezielle Dispenssysteme etc. Derartige Imprintanlagen weisen auch nur selten die Möglichkeit auf, ein Prägematerial auf einem Substrat von mehr als 300 mm zu prägen.

Es existieren Imprintanlagen, welche die Herstellung von Strukturen für Anzeigegeräte, also Displays, insbesondere gebogene oder flache Bildschirme ermöglichen.

Es gibt fünf bekannte Techniken der Imprintlithographie:
- Mikro- und/oder Nanokontaktdrucken (µ/nCP)
- Replikagießen (REM)
- Micro-transfer moulding (µTM) oder nanoimprint lithographie (NIL),
- Mikroformung in Kapillaren (MIMIC)
- lösungsmittelunterstützten Mikroformen (SAMIM).

Es ist bekannt, dass die Imprintstempel in zwei große Familien einteilbar sind: es können harte Stempel (aus Metall, keramischen Werkstoffen oder voluminöses Glas oder Kunststoff) bzw. sog. weiche Stempel (aus Polymeren, Silikonen usw.) verwendet werden.

Elastomere Stempel werden als Negativ eines Masters hergestellt. Beim Masterstempel handelt es sich um einen Hartstempel aus Metall, Glas, Quarzglas, Kunststoff oder Keramik, der durch entsprechend aufwendige Prozesse einmal hergestellt wird. Aus dem Master können dann beliebig viele elastomere Stempel hergestellt werden. Die elastomeren Stempel ermöglichen einen konformen, gleichmäßigen Kontakt über große Oberflächen. Sie sind von ihrem Masterstempel, sowie von den Prägeprodukten zu trennen. Dies ist die Folge einer geringen Oberflächenenergie eines elastomeren Stempels, welche mittels Funktionalisierung, insbesondere Beschichtung erreicht wird. Die elastomeren Stempel sind einfacher vom Substrat trennbar als Hartstempel.

Zur automatisierten Realisierung von soft lithographischen Prozessen ist es nötig, den elastomeren Stempel durch einen Träger zu unterstützen. Derzeit werden Glasträgersubstrate mit verschiedenen Dicken verwendet. Durch die Verwendung dicker Glassubstrate verliert der elastomere Stempel allerdings, zumindest teilweise, seine Flexibilität. So sind die Glasträger einerseits hinreichend dünne Träger aus Glas, welche die notwendige Stabilität für den elastomeren Stempel geben, andererseits jedoch flexibel genug, um die notwendige Flexibilität zu erreichen.

Andere Ausführungsformen von elastomeren Stempeln werden als Schichtsysteme aus Elastomer oder aus Polymer hergestellt: Die mechanischen Eigenschaften wie Stabilität, Elastizität, Ebenheit, Rauheit, können vom Trägerelastomer maßgeblich mitbestimmt werden. Die Strukturen des Stempels werden aus dem Stempelmaterial insbesondere mittels Abformung vom Master erzeugt.

Ein Master kann insbesondere in einem step-and-repeat Prozess (S&R Prozess) hergestellt werden. Das ist vor allem dann vorteilhaft, wenn man sehr große Master herstellen muss. Der Master wird dabei durch einen weiteren, Master-Master, hergestellt. In der Fachsprache nennt man allerdings den Master, von dem die Weichstempel abgeformt werden, meistens Sub-Master und den Master zur Herstellung des Sub-Masters Master. Die Definitionen können also variieren. Es wird offenbart, dass ein, insbesondere großflächiger, Master (bzw. Sub-Master), der zur Abformung von Weichstempeln verwendet wird, durch einen wiederholten Prägeprozess (step-and-repeat Prozess) hergestellt werden kann, der sich dadurch auszeichnet, dass an einer ersten Stelle geprägt, danach der Master-Master (bzw. Master) verfahren und danach mindestens ein weiteres Mal geprägt wird.

Des Weiteren ist denkbar, dass ein Master in einem step-and-repeat Prozess verwendet wird, um direkt den elastomeren Stempel zu prägen. Das ist vor allem dann vorteilhaft, wenn der elastomere Stempel sehr groß ist. Der Master wird dabei an eine erste Position verfahren, prägt dort den elastomeren Stempel, verfährt dann zu einer zweiten, von der ersten Position unterschiedlichen, Position und prägt erneut. Dieser Prozess kann so oft fortgesetzt werden, bis ein elastomerer Stempel beliebiger Größe erzeugt wurde. Insbesondere können die einzeln geprägten Stellen des elastomeren Stempels nahtlos geprägt werden.

Die Verwendung von starren Trägern erschwert im Allgemeinen das automatische Trennen von Stempel und Substrat nach dem Prägeprozess, wodurch eine Prozessautomatisierung und eine industrielle Verwertbarkeit der Imprintlithographie nur schwer möglich sind.

Ein weiteres allgemeines Problem von Stempeln besteht darin, dass sie meistens nur eine begrenzte Größe besitzen. Dadurch wird es nicht ohne weiteres möglich, große Flächen zu prägen. Eine Möglichkeit einer kontinuierlichen Prägung stellen Rollenstempel dar, die hier aber nicht weiter behandelt werden sollen. Für die Prägung von mikro- und/oder nanometergroßen Strukturen auf großen Substraten, insbesondere Platten, existieren im Stand der Technik nur sehr wenige und vor allem keine ausgereiften Anlagen oder Methoden.

Ein weiteres Problem besteht in der Ablösung des Stempels von den Flächen. Die Stempelablösung muss präzise kontrolliert erfolgen, so dass die geprägte Struktur und der Stempel bei der Entformung des Stempels keinen Schaden nehmen.

Ein weiteres Problem, insbesondere von Stempeln für große Substrate, besteht darin, dass die Strecken zum Prägen bzw. zur Trennung des Substrats vom Stempel mindestens die doppelte Strecke einer charakteristischen Länge des Substrates benötigen. Demnach beanspruchen solche Vorrichtungen extrem viel teure Reinraumfläche. Mit anderen Worten besteht bei der Ablösung des Stempels das Problem darin, dass der Platzbedarf der Trennung des Stempels von der Prägefläche mit der Länge bzw. Durchmesser des Stempels skaliert, falls die Trennung auf einer linearen Abhebebewegung basiert. Diese Methode ist mit anderen Worten ein Abschälen des flexiblen Stempels vom Substrat mit hohen Scherkräften.

Demnach benötigt ein Trennmechanismus einer Imprintvorrichtung für eine lineare Abhebebewegung eine durch die Länge des Stempels, Elastizität des Stempels sowie Hafteigenschaften festlegbare, experimentell ermittelbare Strecke, welche von einer Stempelseite zur Trennung des Stempels vom Substrat zurückgelegt werden muss. Diese Strecke kann mittels eines modifizierten Tangenshebels beschrieben werden. Da die Länge eines Tangenshebels variabel ist, verändert sich die Länge des gespannten Stempels. Eine Längenänderung des Stempels ändert ohne zusätzliche Kompensation die Materialspannung, welche auch eine Veränderung in der Maßhaltigkeit des Stempels bedeutet.

Alternative Ausführungsformen von Trennmechanismen verwenden Umlenkrollen, um die Trennung effizienter zu gestalten. Die Richtung des Stempels wird an einer Umlenkrolle geändert, sodass der Platzbedarf der Vorrichtung im Vergleich zu Ausführungsformen ohne Umlenkrollen verringert werden kann. Bei der Richtungsänderung des Stempels ändern sich die Kraftwirkungen und somit die einzelnen Komponenten des Spannungstensors im Stempel, also ist die konstante Maßhaltigkeit des Stempels nicht gewährleistet.

Weder bei einem Trennmechanismus mit Tangenshebel als auch mit Umlenkrollen kann eine konstante Maßhaltigkeit des Stempels gewährleistet werden, obwohl eine konstante Maßhaltigkeit eines Stempels während des gesamten Prägevorgangs ein grundlegend wichtiger Aspekt aller Prägevorgänge ist.

Der Stand der Technik für die Mikro- und/oder Nanostrukturierung von Oberflächen umfasst vor allem die Photolithographie und die unterschiedlichen Prägetechniken. Die Prägetechniken arbeiten entweder mit harten oder weichen Stempeln. In letzter Zeit setzen sich vor allem die Prägelithographietechniken durch und verdrängen die klassischen Photolithographietechniken. Unter den Prägelithographietechniken wird vor allem die Verwendung von sogenannten weichen Stempeln immer beliebter. Der Grund liegt in der leichten Herstellung der Stempel, effizienten Prägevorgängen, sehr guten Oberflächeneigenschaften der jeweiligen Stempelmaterialien, den geringen Kosten, der Reproduzierbarkeit des Prägeproduktes und vor allem in der Möglichkeit der elastischen Verformung des Stempels während dem Prägen und der Entformung. In der Softlithographie wird ein Stempel aus einem Elastomer mit einer mikro- bzw. nanostrukturierten Oberfläche verwendet, um Strukturen im Bereich von 10 nm bis größer 1000 µm herzustellen.

Neben den Vorteilen der Imprintlithographie mit weichem Stempel gibt es den Nachteil derselben Technologie, welche aus der Elastizität des Stempels resultiert, so dass die Maßhaltigkeit des Stempels nicht immer gewährleistet wird. Dies führt zu Ungenauigkeiten sowie Verzerrungen der abgebildeten, geprägten Strukturen im Vergleich zu den prägenden Strukturen des Stempels. Dieser materialbedingte Nachteil wird mit der vorliegenden Erfindung ebenfalls zumindest reduziert.

Es hat sich als nachteilig herausgestellt, dass der Strukturstempel während dem Prägen der Strukturen und dem Trennen des Strukturstempels von der Prägemasse unterschiedlichen Spannungen ausgesetzt ist, wodurch die Abstände zwischen den Strukturen des Strukturstempels variieren, sodass die Maßhaltigkeit der erzeugten Strukturen in der Prägemasse nicht optimal ist. Es ist daher die Aufgabe der Erfindung, eine verbesserte Vorrichtung und ein verbessertes Verfahren zum Prägen von Strukturen, insbesondere Mikro-und/oder Nanostrukturen, anzugeben, die die Nachteile des Stands der Technik nicht mehr aufweisen und mit denen insbesondere eine Automatisierung und eine schnellere Bearbeitung der Substrate mit verbessert maßhaltigen Prägestrukturen gewährleistet werden kann.

Diese Aufgabe wird mit dem Gegenstand der nebengeordneten Patentansprüche gelöst. Vorteilhafte Weiterbildungen der Erfindung sind in den Unteransprüchen angegeben.

Erfindungsgemäß vorgesehen ist eine Vorrichtung zum Prägen von Strukturen in eine Prägemasse, aufweisend einen Strukturstempel zum Prägen der Strukturen in die Prägemasse, wobei der Strukturstempel während des Prägens und des Trennens von der Prägemasse unter einer konstanten lokalen Dehnung haltbar ist.

Weiterhin erfindungsgemäß vorgesehen ist ein Verfahren zum Prägen von Strukturen in eine Prägemasse, wobei ein Strukturstempel die Strukturen in die Prägemasse prägt, wobei der Strukturstempel während des Prägens und des Trennens von der Prägemasse unter einer konstanten lokalen Dehnung gehalten wird.

Das Merkmal "konstant" im Sinne dieser Erfindung bedeutet, dass die lokale Dehnung an jeder Stelle des Strukturstempels zumindest annähernd gleich ist. Darunter wird verstanden, dass die lokale Dehnung um maximal 100 ppm bezogen auf den Mittelwert variiert.

Erfindungsgemäß ist eine Prägerolle zum Drücken der Strukturen des Strukturstempels in die Prägemasse vorgesehen, wobei die Prägerolle Mitnehmer zum Abheben des Strukturstempels nach dem Prägen aufweist. Vorteilhaft kann dadurch auf eine zusätzliche Abtrennvorrichtung verzichtet werden.

Bevorzugt ist weiterhin eine Vorrichtung vorgesehen, wobei die Prägerolle mit dem Strukturstempel nach dem Prägen von einer Endposition auf einer Trennbahn zurück zu einem Startpunkt einer erneuten Prägung beweglich ist bzw. bewegt wird. Vorteilhaft kann dadurch ohne Unterbrechung der nächste Prägevorgang begonnen werden.

Die Erfindung betrifft insbesondere eine Vorrichtung zum Prägen von Mikro-und/oder Nanostrukturen mit einem Strukturstempel, wobei der Strukturstempel verbesserte Handhabungseigenschaften aufweist, wobei der Strukturstempel verbesserte Maßhaltigkeit besitzt, wobei die Vorrichtung konstruktiv platzsparend die Trennung des Strukturstempels vom Substrat ermöglicht und wobei die Maßhaltigkeit des Strukturstempels beim Prägevorgang erhalten bleibt.

Eine weitere nicht erfindungsgemäße Vorrichtung zum Prägen von Mikro- und/oder Nanostrukturen wird erläutert, wobei die Übertragung der Strukturen an die Prägemasse lediglich mit der Verformung des Strukturstempels ohne rückseitige Krafteinwirkung mittels Fluid- oder Prägerolle erfolgt und wobei die Maßhaltigkeit des Strukturstempels beim Prägevorgang erhalten bleibt.

Die Erfindung betrifft weiterhin Verfahren zum Prägen von Mikro- und/oder Nanostrukturen, wobei die Prägeverfahren eine bessere Imprint- sowie Stempelmaßhaltigkeit mittels geregelter Trennung des Substrats vom Strukturstempel ermöglichen, insbesondere wird die Materialspannung im Strukturstempel beim Prägen und bei der Trennung geregelt. Damit wird erreicht, dass die lokale Dehnung des Strukturstempels konstant bleibt und somit die Maßhaltigkeit des Strukturstempels, insbesondere der Prägestrukturen verbessert wird.

Die Erfindung regelt die Krafteinwirkung auf den Stempel insbesondere während des Trennvorgangs, dadurch wird der Strukturstempel, der Träger, sowie der Imprint weniger belastet. Die begrenzte Belastung erhöht die Prägequalität, verlängert die Lebensdauer des Strukturstempels.

Der neuartige, erfindungsgemäß durchgeführte Trennvorgang mit der Trennvorrichtung hat weniger Platzbedarf als herkömmliche Trennmethoden. Dadurch kann insbesondere Grundfläche der Gesamtanlage reduziert werden, welche wiederum die Kosten im Reinraum senkt.

Eine erste erfindungsgemäße Ausführungsform der Vorrichtung besteht aus einer Substrathalterung, aus dem abzuformenden Strukturstempel, aus Befestigungselementen für den Strukturstempel, aus der Prägerolle und aus der Trennvorrichtung und aus den weiter unten aufgeführten Komponenten. Die Vorrichtung beinhaltet weiterhin die Führungen und die Messsysteme und die Energie- sowie Medienversorgung (CDA, Vakuum, Prozessgase, Kühlwasser, etc.) und die Positionier- und Bewegungsvorrichtungen (Antriebe, Bremsen, Fixierungen, Klemmen, insbesondere aktiv schwingungsgedämpftes Gestell, etc.) und die insbesondere zentrale Steuer-und/oder Regeleinheit als Computer und/oder als FPGA ausgeführt).

Weiterhin ist für ein erfindungsgemäßes Verfahren ein mit der Prägemasse beschichtetes Substrat unerlässlich.

Mindestens zwei produktive Betriebszustände können einer Vorrichtung zum Prägen zugeordnet werden: den Prägezustand und den Trennzustand. Im Prägezustand wird ein Strukturstempel abgeformt. Im Trennzustand wird der Strukturstempel vom abgeformten Substrat getrennt.

Die Vorrichtung verwendet unterschiedliche Komponenten im Präge- sowie im Trennzustand, dementsprechend ist eine Aufteilung der Vorrichtungsparameter zweckdienlich. Die Merkmale der Vorrichtung werden möglichst in der oben aufgeführten Reihenfolge der Komponenten und mit Beschreibung der Relationen der Komponenten zueinander aufgeführt.

### Substrathalterung

Die Substrathalterung kann ein mit Prägemasse beschichtetes Substrat fixieren. Dazu können unterschiedliche Fixierungsmechanismen verwendet werden.

Bei den Fixierungen kann es sich um
- Mechanische Fixierungen, insbesondere Klemmen,
- Vakuumfixierungen, insbesondere mit einzeln ansteuerbaren/ geregelten Vakuumbahnen oder miteinander verbundenen Vakuumbahnen,
- elektrische Fixierungen, insbesondere elektrostatische Fixierungen,
- elektronisch ansteuerbaren und/oder geregelten Fixierungen,
- magnetische Fixierungen,
- Adhäsive Fixierungen, insbesondere sog. Gel-Pak Fixierungen,
- Fixierungen mit adhäsiven, insbesondere ansteuerbaren Oberflächen und/oder
handeln.

Die Vakuumfixierung ist die bevorzugte Fixierungsart. Die Vakuumfixierung besteht vorzugsweise aus mehreren Vakuumbahnen, die an der Oberfläche des Probenhalters austreten. Die Vakuumbahnen sind vorzugsweise einzeln ansteuerbar und/oder regelbar. Bevorzugt können mehrere Vakuumbahnen gezielt zu Vakuumbahnsegmenten vereint, gruppiert werden, die einzeln ansteuerbar, daher evakuiert oder geflutet werden können. Jedes Vakuumsegment ist allerdings unabhängig von den anderen Vakuumsegmenten. Damit erhält man die Möglichkeit des Aufbaus einzeln ansteuerbarer Vakuumsegmente. Die Vakuumsegmente sind vorzugsweise ringförmig konstruiert. Dadurch wird eine gezielte, radialsymmetrische, insbesondere von innen nach außen durchgeführte Fixierung und/oder Loslösung eines Substrats vom Probenhalter ermöglicht. Dies ist für rotationssymmetrische Substrate vorteilhaft.

Für Substrate anderer Formgebung wie rechteckige Substrate oder Paneele ist die Aufteilung der Vakuumsegmente parallel zu den Seiten des Substrats vorteilhaft. Besonders vorteilhaft folgt die Ausbildung bzw. Schaltverfahren der Vakuumsegmente formkongruent zur Form des jeweiligen Substrats ausgebildet. Dies ermöglicht einen flexiblen Einsatz des Probenhalters für variable Substratformen. Die Substrate können insbesondere zu prägende nicht-ebene Flächen bzw. Freiformflächen aufweisen.

Die Substrate können jede beliebige Form besitzen, sind aber bevorzugt kreisrund. Der Durchmesser der Substrate ist insbesondere industriell genormt. Für Wafer sind die industrieüblichen Durchmesser, 1 Zoll, 2 Zoll, 3 Zoll, 4 Zoll, 5 Zoll, 6 Zoll, 8 Zoll, 12 Zoll und 18 Zoll. Die erfindungsgemäße Ausführungsform kann aber grundsätzlich jedes Substrat, unabhängig von dessen Durchmesser handhaben. Rechteckige Substrate werden geläufig als Paneele bezeichnet.

### Strukturstempel und Befestigung für den Strukturstempel

Der Strukturstempel hat bevorzugt folgende charakteristische Eigenschaften: Die Stempelseite beinhaltet die abzuformenden Strukturen als Negativbild. Beim Abformen des Strukturstempels werden aus den Erhebungen des Strukturstempels die Vertiefungen der Prägemasse entstehen. Dementsprechend wird die Topographie der Stempelseite ein Negativ der erwünschten Topographie beinhalten.

Die Rückseite des Strukturstempels ist die gegenüber der Stempelseite liegende Fläche. Auf der Rückseite des Strukturstempels rollt bevorzugt eine Prägerolle entlang.

Mindestens zwei gegenüberliegende Enden des Strukturstempels dienen zur Befestigung des Strukturstempels in der Vorrichtung. Bevorzugt werden zur Befestigung des Strukturstempels Befestigungselemente verwendet.

In einer besonders bevorzugten Ausführungsform können die Befestigungselemente in den Strukturstempel teils materiell, teils funktional integriert werden.

Der Strukturstempel wird mit der Stempelseite in Richtung des Substrathalters weisend in der Vorrichtung befestigt. Es wird angenommen, dass ein mit Prägemasse beschichtetes Substrat auf dem Substrathalter fixiert wird.

Die eigentliche Positionieraufgabe ist die Ausrichtung der Prägeseite des Stempels zum mit Prägemasse beschichteten Substrat. Dies wird durch die Positionierung der Befestigungsmittel des Strukturstempels zum Substrathalter in der Vorrichtung erreicht. Da sich die Ausführungsformen der Vorrichtungen voneinander unterscheiden, wird sich hier bevorzugt auf die tatsächliche Positionier- und Präge- und Trennaufgabe konzentriert. Die dazu notwendigen Vorrichtungsparameter sind bei der Auslegung, Gestalt und Betrieb der Vorrichtung einfach aus den Parametern abzuleiten.

Der Strukturstempel wird relativ zum Substrat bzw. sinngemäß zum Substrathalter in einer Relativbewegung ausgerichtet und sie werden zueinander justiert.

Im weiteren Verlauf des Textes werden unterschiedliche Parametersätze offenbart. Viele Parametersätze beziehen sich auf die statistischen Merkmale Genauigkeit und Präzision.

Unter Genauigkeit wird ein systematischer Fehler verstanden. Ein systematischer Fehler ist die Abweichung des statistisch aus der Stichprobenmenge ermittelten Erwartungswerts eines Parameters vom wahren Wert der Population. Je größer die Genauigkeit, desto kleiner der Wert der Abweichung, also desto kleiner der systematische Fehler.

Unter Präzision wird die Streuung einer Messgröße um den Erwartungswert der Stichprobenmenge verstanden. Je größer die Präzision, desto kleiner ist die Streuung.

Der Strukturstempel liegt vor dem Prägen bevorzugt mittels Befestigungselementen uniaxial eben eingespannt über der Oberfläche der Prägemasse. Bevorzugt wird der Strukturstempel in einem Winkel unter 10 Grad, bevorzugt unter 6 Grad, besonders bevorzugt unter 3 Grad im optimalen Zustand unter 1 Grad, im idealen Zustand parallel zum Substrat eingestellt.

Der freie Abstand zwischen Strukturstempel und Prägemasse vor dem Prägen beträgt weniger als 1 mm, bevorzugt weniger als 500 Mikrometer, besonders bevorzugt weniger als 50 Mikrometer. In besonders bevorzugten Ausführungsformen beträgt der freie Abstand zwischen Strukturstempel und Prägemasse vor dem Prägen weniger als 10 mm, besonders bevorzugt weniger als 25 Mikrometer, ganz besonders bevorzugt weniger als 10 Mikrometer, in einem optimalen Fall weniger als 5 Mikrometer.

Der Strukturstempel kann in einer bevorzugten Ausführungsform durch einen Träger verstärkt, mit anderen Worten unterstützt werden. Als Träger können dünne, optisch homogene, mechanisch isotrope Werkstoffe, insbesondere Folien verwendet werden.

Es können folgende Werkstoffe und/oder deren Kombinationen und/oder deren Blends für das Material des Trägers verwendet werden:
- Gläser (Borosilikat-, Fluor-, Sapphirglas)
- Polydimethylsiloxan (PDMS)
- Perfluoropolyether (PFPE)
- Polyhedrales oligomerisches Silsesquioxan (POSS)
- Polydimethylsiloxan (PDMS)
- Tetraethylorthosilicat (TEOS)
- Poly(organo)siloxane (Silikon)
- Thermoplaste
- Duroplaste
- Polymere
- Elastomere
- Polyimide (PI)
- Polyethylenterephtalate (PET)
- Polyamide und/oder
- Kohlenstoff.

Alle aufgeführten Werkstoffe können auch als Fasermaterialien verwendet werden.

In bevorzugten Ausführungsformen können insbesondere die Träger in Urformverfahren insbesondere wie Gießen, Spritzgießen, Walzen, Extrusionsblasen hergestellt werden.

Das Material für den Strukturstempel mindestens eine der folgenden Werkstoffe oder deren Kombinationen und/oder deren Blend aufweisen:
- Polydimethylsiloxan (PDMS)
- Perfluoropolyether (PFPE)
- Polyhedrales oligomerisches Silsesquioxan (POSS)
- Polydimethylsiloxan (PDMS)
- Tetraethylorthosilicat (TEOS)
- Poly(organo)siloxane (Silikon)
- Thermoplaste
- Duroplaste
- Polymere
- Elastomere.

In besonders bevorzugten Ausführungsformen eines insbesondere zusammengesetzten Strukturstempels kann der Träger durch eine räumliche Formgebung eine vorteilhafte Funktionsintegration erreichen. Zumindest zum Teil können die Befestigungselemente mit dem Träger insbesondere in einem Urformverfahren hergestellt sein.

Die Dicke des Trägers ist in dieser Ausführungsform variabel. Der Träger beinhaltet einen Teil, eine Zone mit einer ersten, insbesondere homogenen Dicke im Bereich des Strukturstempels, welcher Teil abgeformt wird und einen weiteren Teil, eine weitere Zone mit einer zweiten, variablen Dicke, welche insbesondere als Befestigungselement ausgebildet werden kann.

In einer weiteren Ausführungsform können Sensoren, insbesondere Kraftmesssensoren, oder optische Brechungs- bevorzugt Doppelbrechungssensoren, Polarisationssensoren an der Randzone der ersten, homogenen Dicke des Strukturstempels angeordnet werden. Die elektrischen Kontakte und/oder optischen Koppler der Auswertungselektronik werden entsprechend am Befestigungselement in der weiteren Zone im Volumen des Trägers integriert.

In dieser vorteilhaften Ausführungsform sind die Dehnungseigenschaften aller aufgeführten Komponenten (Träger, Sensoren, Zuleitungen, Strukturstempel, Kontakte) aneinander angeglichen.

### Prägerolle

Die Prägerolle ist bevorzugt ein zylindrischer oder tonnenförmiger (rotationsellipsoider) Körper mit einer wohldefinierten Rotationsachse und einer Mantelfläche. Mit anderen Worten ist die Prägerolle eine Walze, eine mindestens einseitig angetriebene, mindestens an einem Ende geführte, insbesondere gelagerte Walze. Eine Lagerung der Prägerolle ermöglicht die Rotation der Prägerolle, die Führung der Prägerolle ermöglicht eine Translation der Prägerolle entlang der Führung.

In speziellen Ausführungsformen ist die Prägerolle eine rotationsellipsoide Walze, mit welcher nicht ebene Substrate geprägt werden können.

Die Mantelfläche der Prägerolle wird zum Prägen mit der Rückseite des Strukturstempels in Kontakt gebracht, um die Prägeseite des Strukturstempels in der Prägemasse abzuformen.

Die Oberflächengüte der Mantelfläche wird bevorzugt zumindest in polierter, bevorzugt geläppter Güte hergestellt. Anders formuliert ist die Prägerolle bevorzugt "spiegelglatt", unabhängig vom eingesetzten Werkstoff.

Die Prägerolle wird mindestens an einem Ende gelagert bzw. geführt, um die notwendigen Bewegungen zum Prägen ausführen zu können.

Eine erfindungsgemäße Prägerolle hat einen Mantelflächendurchmesser größer 10 mm, bevorzugt größer 15 mm, besonders bevorzugt größer 30 mm, ganz besonders bevorzugt größer 70 mm, im optimalen Fall größer 120 mm. Kleinere Substrate bzw. kleinere Strukturstempel werden bevorzugt mit Prägerollen geringeren Durchmessers geprägt als großflächige Substrate, und/oder Paneele.

Die Prägerolle wird ab einer bestimmten Anfangsposition das Prägen durchführen, dazu werden die entsprechenden Regelschleifen, Messsysteme sowie Antriebe geschaltet und geregelt. Die Prägerolle lenkt den Strukturstempel aus, sodass der Strukturstempel mit der Prägemasse in Berührung kommt. Dazu wird eine insbesondere Linienkraft der Prägerolle auf die rückseitige Oberfläche des Strukturstempels ausgeübt. Bevorzugt lenkt die Prägerolle den Strukturstempel so aus, dass die Kapillarkräfte der Prägemasse ausreichen, den Strukturstempel anzuziehen.

Das Kraftverhältnis der Kapillarkraft der Prägemasse, ausgeübt auf den Strukturstempel, als Linienkraft berechnet, zur ausgeübten Kraft der Prägerolle auf den Strukturstempel ist 100:1, bevorzugt 50:1, besonders bevorzugt 10:1. Die resultierende Kraft aus der Kapillarkraft und aus der Linienkraft der Prägerolle (evtl. zusätzlich Gravitationskraft) verrichtet die Urformarbeit der Prägemasse. In weiteren Ausführungsformen beträgt das Kraftverhältnis der Kapillarkraft zur ausgeübten Kraft der Prägerolle auf den Strukturstempel 2:1, besonders bevorzugt 1:1, ganz besonders bevorzugt 1:5, in einem weiteren Fall 1:10.

In einer weiteren bevorzugten Ausführungsform ist die Prägekraft zumindest teilweise einstellbar, besonders bevorzugt regelbar, insbesondere konstant.

Die Regelung der Prägekraft kann mittels geregelter Einstellung und Nachstellung der Prägerolle in der Normalrichtung der Prägestempelrückseitenfläche erfolgen. Dabei wird eine Prägekraft zwischen 0 N bis 50000 N, bevorzugt 0 N bis 10.000 N, besonders bevorzugt 0N bis 1000 N, ganz besonders bevorzugt 0 N bis 150 N als Linienkraft erbracht.

Eine Beeinflussung, insbesondere Regelung, der Prägekraft kann mittels einer variabel einstellbarer, an sich homogen verteilten, Masse der Prägerolle erfolgen. Eine Einstellung der Masse der Prägerolle kann mit zusätzlich im Inneren der Prägemasse zugefügtem Gewicht wie eine Flüssigkeit, Metallkugeln, Sand etc. erfolgen. Weiterhin kann eine Beeinflussung, insbesondere Regelung der Prägekraft mit der Einstellung der Kapillarkraft zwischen Strukturstempel und Prägemasse beeinflusst werden. Dazu können die Parameter Viskosität mittels Lösungsmittelgehalt, und/oder Temperatur und/oder Additive beeinflusst werden.

Die Viskosität der Prägemasse liegt zwischen 0,01 cPoise bis 10000 cPoise, bevorzugt zwischen 1 cPoise und 500 cPoise, besonders bevorzugt zwischen 2 cPoise und 300 cPoise.

Die Temperatur der Prägemasse (bevorzugt auch die Temperatur des Substrats und des Substrathalters) ist zwischen 0°C und 300°C, bevorzugt zwischen 15°C und 120°C, besonders bevorzugt zwischen Raumtemperatur (insbesondere 20°C) und 75°C.

Die Temperaturschwankung der Prägemasse beim Prägen ist kleiner +/- 5 K, bevorzugt kleiner +/-3 K, besonders bevorzugt kleiner +/- 1 K, ganz besonders bevorzugt kleiner +/- 0,5 K, im optimalen Fall kleiner +/- 0,1K.

Die Prägemasse kann als Additive Flussmittel und/oder Radikalfänger und/oder Radikalverminderer und/oder Sauerstoffinhibitorenhemmer, insbesondere auf Basis modifizierter Acrylate, beinhalten.

Die Prägerolle ist in einer ersten Ausführungsform eine mindestens einseitig angetriebene, an beiden Enden geführte, insbesondere gelagerte Walze. Bei der bevorzugt starren Walze wird die äußere Mantelfläche bevorzugt mit einem elastischen Material ausgebildet. Das elastische Material der Prägerolle erhöht bevorzugt die Haft- bzw. Rollreibung zum Strukturstempel. Weiterhin nimmt die Oberfläche der Prägerolle mit dem elastischen Material, insbesondere ein vernetztes Polymer-Gerüst, kleinste Partikel, welche auf der Rückseite des Strukturstempels liegen, insbesondere reversibel auf, und bettet sie so ein, dass die Partikel nicht das Ergebnis des Imprints beeinflussen.

Insbesondere kann die Prägerolle mit einer Signaländerung (Farbe, Doppelbrechung, elektrische Leitfähigkeit) eine notwendige Reinigung wegen der eingebetteten Partikel beim Prägen signalisieren.

In dieser Schrift wird zwischen einem Strukturstempel ohne Träger bzw. einem Strukturstempel mit Träger nicht unterschieden, sodass sich die aufgeführten Eigenschaften und Merkmale auf Ausführungsformen mit und ohne Träger beziehen können.

Die Lagerung der Prägerolle ist bevorzugt gegen das Verkanten gesichert. In einer ersten Ausführungsform ist die Prägerolle einseitig mit mindestens zwei voneinander beabstandeten Führungselementen gelagert, sodass ständig Rollreibung als Lagerreibung auftritt. Die Antriebsseite ist die nicht gelagerte Seite. Mit anderen Worten wird die Prägerolle auf einer Seite mit zwei Lagern gelagert, um entlang der Führungsbahn entlangfahren zu können und auf der anderen Seite hat die Prägerolle eine insbesondere lösbare Kupplung zur Kraft- bzw. Stellwegeinkopplung.

In einer zweiten Ausführungsform der Prägerolle werden beide Enden der Prägerolle gelagert und synchronisiert angetrieben, Dies führt zur Minimierung der Scherkräfte entlang der Prägerolle, insbesondere auf dem Strukturstempel.

Während des Prägevorgangs wird der Strukturstempel in der Prägemasse auf der Substratoberfläche abgeformt. Die Prägerolle kann insbesondere mit konstanter Geschwindigkeit entlang der Länge des Strukturstempels abrollen oder ein bestimmtes Geschwindigkeitsprofil abfahren. Insbesondere wird die verrichtete Urformarbeit konstant gehalten. Dies kann mit der Variation der Geschwindigkeit der Prägerolle und/oder mit der Variation, bevorzugt mit einer geregelten Beeinflussung, der Prägekraft bzw. des Prägedrucks erfolgen.

Die Prägerolle führt bevorzugt eine Rollbewegung auf der Rückseite des Strukturstempels durch und verrichtet dabei zumindest teilweise die Urformarbeit der Prägemasse.

Die Führung der Prägerolle ist in einer Ausführungsform der Vorrichtung mindestens eine Geradführung, bevorzugt mindestens eine prismatische Geradführung. Die Leitgerade der Geradführung hat bevorzugt eine Abweichung vom Idealen kleiner 500 Mikrometer, bevorzugt kleiner 100 Mikrometer, besonders bevorzugt kleiner 10 Mikrometer, ganz besonders bevorzugt kleiner 1 Mikrometer, bezogen auf die Gesamtlänge.

Mit einer weiteren Führung der Prägerolle wird eine theoretische Ebene aufgespannt. Bevorzugt ist die aufgespannte Ebene, die Prägeebene, deckungsgleich mit der zu prägenden Substratoberfläche. Besonders bevorzugt ist die Prägeebene eine parallel zur Substratoberfläche aufgespannte, um die Strukturstempeldicke versetzte Ebene.

In einer besonders bevorzugten Ausführungsform der Vorrichtung beinhaltet die Führung der Prägerolle zwei Geradführungen, welche zueinander um +/-15 Grad, bevorzugt um +/- 10 Grad, besonders bevorzugt um +/- 5 Grad justierbar sind, um die Prägeebene einstellen und nachstellen zu können. Die Justierung beinhaltet Stellmittel für die Parallelstellung der Geradführungen zueinander. Die Parallelität ist besser als 1 Grad, bevorzugt besser als 0,5 Grad, besonders bevorzugt besser als 0,1 Grad.

In weiteren bevorzugten Ausführungsformen der Vorrichtung ist die Führung der Prägerolle als eine Trajektorie der insbesondere nicht ebenen zu prägenden Substratoberfläche ausgebildet. Die so beschriebene Ausführungsform der Führung der Prägerolle ermöglicht eine maßgebend parallele Führung der Prägerolle zum Substrat, welche eine insbesondere konstante Restschichtdicke der Prägemasse zur Folge hat. Um die Vorrichtung vielseitig einsetzen zu können ist es vorgesehen, die Führung der Prägerolle insbesondere automatisiert umrüstbar auszuführen. Dabei bildet die Führung der Prägerolle die jeweilige ideal angesehene Substratform ab.

Wird die Führung der Prägerolle zum Führen der Prägerolle beim Prägen verwendet, dient sie als eine Steuerkurve zum Prägen, mit anderen Worten besitzt die Prägerolle eine Prägebahn.

Die Prägebahn kann bestimmte Positionen beinhalten, welche als Startposition bzw. als Endposition beim Prägen definiert werden. Das später beschriebene Verfahren beginnt das Prägen ab der Startposition und beendet das Prägen in einer Endposition.

Am Ende des Prägevorgangs kann die Prägerolle zunächst in einer bestimmten Endposition verbleiben oder zu einer definierten Startposition zurückkehren.

In einer weiteren Ausführungsform wird die Prägerolle während des Prägevorgangs passiv in Rotation versetzt, also ist die Reibungskraft zwischen Prägerolle und Strukturstempel ausreichend, damit die Prägerolle insbesondere mit geringem Schlupf, bevorzugt schlupffrei, beim Prägen die charakteristische Länge des Strukturstempels abfährt.

In einer weiteren erfindungsgemäßen Ausführungsform besitzt die Prägerolle mindestens zwei Antriebe. Die Antriebe bewegen die Prägerolle voneinander unabhängig geregelt, bevorzug zueinander zweckdienlich synchronisiert in einer Translation sowie in einer Rotation.

Somit ist ein Prägevorgang wie Rakeln durchführbar oder insbesondere eine Schlupfkorrektur möglich, sodass die Drehzahl der Prägerolle, die daraus resultierende Winkelgeschwindigkeit sowie die Vorschubgeschwindigkeit in einer geregelten Antriebsstruktur aufeinander abgestimmt werden und angepasst werden können.

Die Schlupfkorrektur ist ein Maß dafür, wie eine insbesondere elastische Prägerolle einen elastischen Strukturstempel in eine elastische Prägemasse drückend von der ideal berechneten Verfahrensparametern abweicht. Die Abweichungen können als rutschen oder kleben interpretiert werden, also schnellere oder langsamere Drehungen als die bei der Vorschubgeschwindigkeit errechnete ideale Winkelgeschwindigkeit. Das Maß der Schlupfkorrektur gibt über den tatsächlichen Reibungszustand Aufschluss. Bevorzugt wird der Schlupf mittels geregelter Schlupfkorrektur auf ein Minimum gehalten.

### Trennmittel und Trennmechanismen

Die Trennung des Strukturstempels von der geprägten Prägemasse erfolgt nach der Aushärtung der Prägemasse oder zumindest nach einer Initiierung der Aushärtung der Prägemasse. Als Bedingung für eine erfolgreiche Trennung des Strukturstempels von der Prägemasse kann formuliert werden, dass die Adhäsion der Prägemasse zum Strukturstempel gering ist und dass die Formstabilität der geprägten Prägemasse (engl. pattern fidelity) nach der Trennung derart beschaffen ist, dass die Verformung der Prägemasse kleiner 5%, bevorzugt kleiner 2% besonders bevorzugt kleiner 1%, im idealen Fall kleiner 0,01% beträgt.

Bei der Trennung entfernen sich der Strukturstempel und das Substrat in einer Relativbewegung voneinander. Für die erfolgreiche Trennung ist es also unerheblich, ob das Substrat oder der Stempel voneinander abgehoben werden. Zweckmäßig ist an dieser Stelle die Bewegung des Strukturstempels.

Die Trennmittel können als eine insbesondere räumliche Führung, eine sog. Trennbahn für die Prägerolle beinhalten.

Ab der definierten Endposition nach einem Prägevorgang kann die Prägerolle die Trennbahn entlangfahren. Die Trennbahn ist mit anderen Worten eine Steuerkurve, eine räumliche Bahn. Die Trennbahn führt die Prägerolle zumindest vom Substrat, bevorzugt vom Strukturstempel, weg, sodass sich die Prägerolle vom Substrat abhebt und im Wesentlichen parallel zur Prägebahn zu einer definierten Anfangsposition zurückkehrt.

Die Prägerolle hat entsprechend ausgebildete Mitnehmer, welche die Befestigungselemente des Strukturstempels aufnehmen und auf der Trennbahn mitnehmen. Somit wird der Strukturstempel mitgenommen und aus der Prägemasse gelöst.

Mit anderen Worten wird der Strukturstempel, aus der insbesondere horizontalen Lage, durch den Mitnehmer insbesondere auf kleinstem Raum, bevorzugt mit der Prägerolle zusammen bewegt mitgenommen, um eine Trennung unter großem Trennwinkel zu erreichen. Die Materialspannung im Strukturstempel wird dabei konstant gehalten.

Der Trennwinkel beträgt mehr als 0 Grad, bevorzugt mehr als 30 Grad, besonders bevorzugt mehr als 90 Grad, ganz besonders bevorzugt mehr als 120 Grad, im optimalen Fall mehr als 160 Grad.

Der Mitnehmer kann eine formschlüssige Verbindung zwischen den Befestigungselementen des Strukturstempels und der Prägerolle herstellen. Folgende konstruktive Grundideen können als unterschiedliche Ausführungsformen des Mitnehmers entweder sortenrein (beide Enden identisch ausgebildet) oder in Mischform verwendet werden, sodass die Mitnehmer an den Enden der Prägerolle unterschiedlich sind:
- Kugel auf Ebene-Paarung,
- Kugel auf mehreren Ebenen wie V-Nut - Paarung,
- Kegel in Kegelbohrung-Paarung,
- Zylinder-U-Nut-Paarung,
- Zylinder-V-Nut-Paarung, oder auch als Keilnut ausgebildet,
- Zylinder in Zylinder-Paarung,
- Prismatisches Element auf Ebene,
- Prismatisches Element in prismatischem Element,
- Magnet mit Gegenstück, auch als schaltbarer Elektromagnet ausgebildet,
- Bajonettverschluss,
- Steuerkurve und Zylinder (selbstsperrende Steuerkurve, Spirale), und/oder
- lösbarer Schnappverschluss.

Der Mitnehmer kann eine kraftschlüssige Verbindung zur Prägerolle über Reibung herstellen.

Der Mitnehmer kann eine elektromagnetische und/oder permanentmagnetische und/oder elektrostatische und/oder vakuumtechnische Verbindung zur Prägerolle herstellen. Ein materieller Festkörperkontakt findet zwischen Prägerolle und Mitnehmer bevorzugt nicht statt. Mit anderen Worten kann der Mitnehmer und die Prägerolle mit Fluidströmung oder (elektro)magnetischer oder elektrostatischer Kopplung gekoppelt und mit entsprechend ausgeführter Arbeit bewegt werden.

Ein kontrolliertes Ablösen wird durch Optimierung der folgenden Parameter erreicht:
- Höhe der Trennbahn im Bezug zur Prägebahn,
- geregelte Zugkraft der Prägerolle auf der Trennbahn, ausgeübt auf die Befestigungselemente sowie Strukturstempel,
- Länge der Trennbahn,
- Trajektorie (Steuerkurve der Bewegung) des Strukturstempels auf der Trennbahn,
- elektrostatische Spannung zur Abstoßung des Strukturstempels von der ausgehärteten Prägemasse,
- Auswahl/Beeinflussung der Oberflächeneigenschaften, insbesondere das Herabsetzen der Oberflächenenergie durch entsprechende Beschichtungen, und/oder
- Regelung der Ablösetemperatur und/oder thermische Unterstützung des Trennvorgangs, insbesondere mit gezielter Veränderung der Strukturgeometrie mit Ausnutzung der Unterschiede der Wärmedehnungen des Substrats, der Prägemasse und des Strukturstempels in Kenntnis der thermisch-mechanischen Zeitkonstanten der einzelnen Komponenten. Die thermisch-mechanische Gradienten werden verwendet, um den Trennvorgang schneller und effektiver zu gestalten.

Als Beispiel ist folgender Trennvorgang genannt: eine rasche Erwärmung des Substrats und der Prägemasse lässt das Substrat und die Prägemasse ausdehnen. Der nicht gewärmte Strukturstempel kann mit geringerer Krafteinwirkung von der Prägemasse getrennt werden als in einem isothermen Zustand.

Nachdem die Trennung des Strukturstempels vom Substrat erfolgreich abgeschlossen ist, nimmt insbesondere ein Rückführungsmechanismus den Strukturstempel in die Prägeposition zurück und befestigt ihn entsprechend.

Alternativ führt die Prägerolle den Strukturstempel in die Prägeposition und fährt in die definierte Anfangsposition, ohne weitere Beeinflussung des Strukturstempels.

### Verfahren 1

In einem ersten erfindungsgemäßen Verfahren für die Abformung des Strukturstempels in der Prägemasse auf dem Substrat sind folgende Verfahrensschritte vorgesehen.

Als vorbereitende Verfahrensschritte werden die Beschichtung des Substrats mit der Prägemasse, sowie Transport und Befestigung des Substrats auf dem Substrathalter, Befestigung des Strukturstempels in der Vorrichtung etc. verstanden und nicht in Detail beschrieben.

In einem ersten Verfahrensschritt fährt die Prägerolle über das mit der Prägemasse benetzte Substrat und stellt den stoffschlüssigen Kontakt zwischen Strukturstempel und Prägemasse her.

In einem zweiten Verfahrensschritt fährt die Prägerolle die charakteristische Länge des Strukturstempels ab und formt den Strukturstempel insbesondere vollflächig in der Prägemasse ab. Mit anderen Worten fährt die Prägerolle die Prägebahn entlang.

In einem dritten Verfahrensschritt wird die Prägemasse vernetzt. Die Aushärtung der Prägemasse kann als Gesamtfläche erfolgen. Alternativ kann eine nachfahrende Energiequelle die Aushärtung sukzessive initiieren.

In einem vierten Verfahrensschritt erreicht die Prägerolle eine bestimmte Endposition des Strukturstempels.

In einem fünften Verfahrensschritt koppelt die Prägerolle mit dem Mitnehmer an den Strukturstempel an.

In einem sechsten Verfahrensschritt fährt die Prägerolle mit dem daran gekoppelten Strukturstempel die Trennbahn entlang, wodurch die Trennung des Strukturstempels aus der insbesondere ausgehärteten Prägemasse erfolgt. In einem siebten Verfahrensschritt wird der Strukturstempel vollständig von der Prägemasse getrennt. Danach wird das geprägte Substrat entladen.

In einem achten Verfahrensschritt werden Strukturstempel sowie die Prägerolle in die jeweilige Startposition gebracht. In einer bevorzugten Ausführungsform fährt die Prägerolle die Trennbahn in der Gegenrichtung zurück, platziert den Strukturstempel in die Prägeposition, löst den Mitnehmer oder die mehreren Mitnehmer und fährt in eine Startposition zurück.

In einer anderen Ausführungsform wird der Mitnehmer gelöst, ein Mechanismus bringt den Strukturstempel in Prägeposition und die Prägerolle fährt eine definierte weitere Bahn in die Startposition zurück.

### Weitere

### Vorrichtungen (ausgelenkter Strukturstempel)

Eine zweite Ausführungsform der Vorrichtung ist eine Weiterentwicklung der ersten erfindungsgemäßen Ausführungsform der Vorrichtung mit einer Vorspanneinrichtung für eine geregelte, konstante Dehnung des Strukturstempels. Der Strukturstempel hat bevorzugt einen Träger.

Der Strukturstempel wird insbesondere mit geregelter Vorspannung, insbesondere mit einer kontrollierten, insbesondere geregelten konstanten Dehnung eingespannt. Die konstante Dehnung des Strukturstempels wird während der Strukturstempelherstellung sowie Verwendung des Strukturstempels zur Abformung der Prägemasse beibehalten.

Wenn die konstante Dehnung nicht beibehalten werden kann, wird eine Abweichung von der konstanter Dehnung um weniger als 120 Mikrometer auf 200 mm Referenzlänge (ergibt 100 ppm) des Dehnungswertes, bevorzugt weniger als 1 Mikrometer auf 200 mm Referenzlänge (ergibt 5 ppm) , besonders bevorzugt weniger als 500 Nanometer auf 300 mm Referenzlänge (ergibt 1,6 ppm) ganz besonders bevorzugt weniger als 50 Nanometer auf 300 mm Referenzlänge (ergibt 16 ppb) Abweichung von der konstanten Dehnung gehalten.

Dadurch kann eine bessere Maßhaltigkeit der Prägestrukturen gehalten werden. Insbesondere wird dadurch die lokale Maßhaltigkeit der Prägestrukturen durch die konstante lokale Dehnung des Strukturstempels beibehalten. Mit anderen Worten wird eine Minimierung der Veränderung der Dehnung beim Prägen bzw. beim Trennen des Strukturstempels angestrebt, welche eine verbesserte Maßhaltigkeit bewirkt.

Die konstante lokale Dehnung wird als eine ein-eindeutige Wirkung einer insbesondere geregelten Vorspannung der Vorrichtung verstanden, welche den Strukturstempel vorspannt.

Insbesondere bei Strukturstempel aus Polymeren oder Elastomeren kann die konstante lokale Dehnung mit einer geregelten Vorspannung erreicht werden, damit der Relaxation des Materials des Strukturstempels berücksichtigt wird und die Maßhaltigkeit des Strukturstempels verbessert und erhöht wird.

In einem Längsschnitt entlang des Prägestempels bilden die Befestigungspunkte sowie der variable Prägepunkt ein rechtwinkeliges Dreieck, insbesondere mit konstant langer Hypotenuse. Die vorgegebene geometrische Bedingung schreibt eine elliptische Bahn für die konstante Dehnung des Strukturstempels vor.

Der Fehler zwischen der Ellipsenbahn, welche der Strukturstempel mit der Prägerolle fährt, und einer Ebene zum Prägen ist kleiner als 5%, bevorzugt kleiner als 3%, besonders bevorzugt kleiner als 1%. Dies wird mit der Auslegung der geometrischen Bedingungen erreicht, insbesondere mit Abstand der Befestigungspunkte als dem 1,5-fachen der Prägelänge, bevorzugt 2-fachen der Prägelänge, besonders bevorzugt 4-fachen der Prägelänge.

Um den Fehler der Ellipsenbahn zu vermeiden ist es vorteilhaft, ein entsprechend schmiegendes elliptisches Substrat zu verwenden.

Als Anwendungen können insbesondere sog. Virtual reality-Brillen, gebogene Displays wie Fernseher oder Computerbildschirme entstehen. Es ist ebenfalls möglich, die Technologie für interaktive Fahrzeugfenster, insbesondere in die Frontscheibe integrierte Anzeige (insbesondere gebogene Form) oder interaktive Seitenfenster für Schienenfahrzeuge oder Busse (insbesondere ebene Form) anzuwenden.

Die Prägerolle spannt den Strukturstempel zwischen den Befestigungselementen insbesondere geregelt vor. Der Strukturstempel schmiegt sich an die Prägerolle (beim Prägen) in einem Kontaktwinkel kleiner 181 Grad, bevorzugt kleiner 120 Grad, besonders bevorzugt kleiner 90 Grad, ganz besonders bevorzugt kleiner 45 Grad, im optimalen Fall kleiner 30 Grad.

In weiteren bevorzugten Ausführungsformen ist der Kontaktwinkel zischen Strukturstempel und Prägerolle kleiner 5 Grad, bevorzugt kleiner 3 Grad, besonders bevorzugt kleiner 1 Grad.

Große Kontaktwinkel werden bei der kontrollierten Trennung des Strukturstempels mit Hilfe der Prägerolle erreicht. Beim Prägen werden die oben genannten kleinen Kontaktwinkel unter insbesondere 30 Grad bevorzugt. Bevorzugt wird der Strukturstempel uniaxial eingespannt.

In einer weiteren, bevorzugten Ausführungsform der Vorrichtung wird die Vorspannung des Strukturstempels mit einer Regelschleife und Aktuatoren, insbesondere Linearaktuatoren am Strukturstempel eingestellt und die lokale Dehnung des Strukturstempels konstant gehalten. Dabei wird der Abstand der Befestigungspunkte zueinander so geregelt, dass die elliptische Bahn des vorgespannten Strukturstempels variabel ist und in einer beliebigen Position der Prägerolle immer einen tangentialen Punkt der Prägeebene beschreibt. Dabei wird die konstante Dehnung des Strukturstempels beibehalten. Somit lassen sich Ebenen oder sog. Freiformflächen prägen.

Dies wird über die konstruktive Annäherung der jeweiligen Ellipse und der Ebene über elastische und/oder geführte Elemente in einer Steuerkette oder in einer Regelschleife erreicht. In einer besonders bevorzugten Ausführungsform wird die abzuformende ebene Form des Strukturstempels auf der Prägemasse über die geregelte Dehnung und gezielte Längenänderung der beiden Schenkel des theoretischen rechtwinkeligen Prägedreiecks eingestellt.

Der freie Abstand zwischen Strukturstempel und Prägemasse (vor dem Prägen) beträgt weniger als 5 mm, bevorzugt weniger als 1000 Mikrometer, besonders bevorzugt weniger als 500 Mikrometer, ganz besonders bevorzugt weniger als 100 Mikrometer vor dem Prägen.

In weiteren besonders bevorzugten Ausführungsformen wird der freie Abstand zwischen Strukturstempel und Prägemasse weiter reduziert auf weniger als 50 Mikrometer, bevorzugt weniger als 20 Mikrometer, besonders bevorzugt weniger als 10 Mikrometer, ganz besonders bevorzugt weniger als 5 Mikrometer. Der freie Abstand bezieht sich auf ein Minimum zwischen Strukturstempel und Prägemasse, sodass insbesondere die Durchbiegung und/oder freies Hängen des Strukturstempels und/oder die Wirkung einer elektrostatischen Anziehung, Wirkungen von transienten Vorrichtungsschwingungen ebenfalls berücksichtigt werden.

Eine relative Zustellbewegung des Strukturstempels zur Prägemasse und zum Substrat stellt den Kontakt zwischen Prägemasse und Strukturstempel her.

Die Aushärtung der Prägemasse erfolgt zeitgleich, bevorzugt zonenweise, besonders bevorzugt linienförmig, ganz besonders bevorzugt mit einer Spaltprojektion der Aushärtestrahlung. Eine Spaltprojektion kann als eine Spaltlampe oder ein oszillierender Laserstrahl aufgefasst werden. Die Oszillationsgeschwindigkeit ist dabei mindestens 100-fach, bevorzugt mindestens 1000-fach, besonders bevorzugt 10.000-fach höher, als die Geschwindigkeit der Prägerolle, sodass die Aushärtestrahlung flächig wirkt und keine voneinander getrennten Linien aushärtet.

In einer weiteren Ausführungsform der Vorrichtung erfolgt die Aushärtung der Prägemasse zonenweise in geregelten Intervallen. Die Dauer der Intervalle der Anwendung der Aushärtestrahlung und keiner Aushärtestrahlung wird mit Berücksichtigung der Minimierung der thermischen Belastung der Prägemasse und des Strukturstempels in einem Iterativverfahren ermittelt. Dem Fachmann ist diese Regelung als Pulsweitenmodulierung bekannt. Es können jedoch weitere bekannte Regelverfahren angewendet werden.

In einer besonders bevorzugten Ausführungsform der Vorrichtung werden zumindest die Prägerolle und die Quelle zur Aushärtung in einer Einheit funktional integriert. Dadurch entsteht eine Prägerolleneinheit.

Die Prägerolleneinheit kann zumindest eine Prägerolle, eine insbesondere identisch ausgebildete Stützrolle und eine Strahlungsquelle mit Projektionseinrichtung beinhalten.

Bei dieser bevorzugten Ausführungsform der Prägerolle wird sie als doppelt ausgebildetes, beabstandetes Rollenpaar mit der Aushärtevorrichtung dazwischen ausgeführt. Die in der Prägerichtung fahrende erste Rolle wird als Prägerolle betrachtet, die insbesondere kontinuierlich arbeitende Aushärtevorrichtung vernetzt die Prägemasse und die nachfolgende Prägerolle als Stützrolle ermöglicht die kontrollierte Trennung des Substratstempels von der ausgehärteten Prägemasse.

Die Prägerolleneinheit kann in einer anderen Ausführungsform zumindest eine Prägerolle und eine Stützrolle beinhalten. In der Stützrolle kann eine Strahlungsquelle, insbesondere eine Wärmequelle integriert sein. Mit anderen Worten wird die eine Rolle der Prägerolleneinheit als Prägerolle verwendet, die andere Rolle wird als beheizte Rolle als thermische Aushärtevorrichtung verwendet, als Aushärtevorrichtung in die Prägerolleneinheit integriert. Eine weitere Ausführungsform kann eine Strahlungsquelle für die Vernetzungsstrahlung, insbesondere eine UV-Lichtquelle beinhalten. Dabei wird die Stützrolle für die Vernetzungsstrahlung transparent ausgebildet.

In einer besonders vorteilhaften Ausführungsform können die Stützrolle und die Prägerolle in der Prägerolleneinheit insbesondere geregelt den Abstand voneinander ändern, um den Spannungszustand des Strukturstempels einzustellen. Sind die Rollen nah beieinander, wird der Strukturstempel weniger vorgespannt, als wenn die Rollen auf maximalen Abstand voneinander gehalten werden. Es können insbesondere spielarme, besonders bevorzugt spielfrei, vorgespannte, beidseitig ausgeführte Pantographen als Stellmechanismen verwendet werden. Es sind jedoch beliebige Stellvorrichtungen mit Selbsthaltevermögen und mit Spielfreiheit verwendbar.

Für die Regelung der Vorspannung des Strukturstempels können im und/oder am Strukturstempel Dehnungssensoren, insbesondere Dehnungsmessstreifen, integriert werden. In weiteren Ausführungsformen des Strukturstempels werden die Dehnungsmessstreifen an den Strukturstempel angebracht. Es können weiterhin Kraftmesszellen für die Spannkraft des Strukturstempels mit dem Ist-Wert insbesondere mehrerer Dehnungsmessstreifen abgeglichen werden. Als Regelgröße kann der gemessene Spannungszustand des Strukturstempels aufgefasst werden. Für die dazu korrelierenden geregelten Größen können die einzeln oder in Kombination verstellten Positionen der Rollen zueinander und/oder die Position der Prägerolleneinheit und/oder die Position bzw. die Spannkraft der Haltevorrichtung des Strukturstempels verwendet werden.

Die Zeitkonstante der Regelung ist bevorzugt 1/10, besonders bevorzugt 1/100, besonders bevorzugt 1/1000 der Zeitkonstante der schnellsten Bewegung der Vorrichtung. Die Regelgeschwindigkeit (Geschwindigkeit der Stellglieder) ist gleich schnell wie die schnellste Bewegung der Vorrichtung.

Die Regler werden insbesondere als Computerprogramme sowie Routinen ausgeführt. Insbesondere vorteilhaft ist die Ausführung der Regler auf Genauigkeit (Vorspannungs-, Positionierungs-, Maßhaltigkeitsgenauigkeit) und Schnelligkeit ausgelegt, jedoch ist ein Überschwingen, ein Überheben der Regelgröße abweichend vom Sollwert nicht bevorzugt. Die Regelparameter, abgeleitet aus der Differenz der Sollwert der Spannung des Strukturstempels und aus dem Ist-Wert, werden so ausgelegt, dass zu jedem Zeitpunkt des Prägeprozesses und des Trennprozesses ein "Hochschaukeln", eine insbesondere harmonische Schwingung unterbunden werden.

Die mechanische Spannung des Strukturstempels liegt zwischen 0,001 MPa und der jeweiligen Streckgrenze des Strukturstempels (und/oder des Trägers bevorzugt zwischen 1 MPa und 2 MPa. Ist die Streckgrenze des Strukturstempels kleiner als die Streckgrenze des Trägers, gelten die aufgeführten Parameter für den Strukturstempel. Generell gelten die mechanischen Spannungsparameter für den Werkstoff mit niedrigerer Streckgrenze. Somit kann eine Überbeanspruchung des Strukturstempels vermieden werden.

Die mechanische Spannung des Strukturstempels wird besonders bevorzugt geregelt. Die mechanische Spannung des Strukturstempels kann im Zeitverlauf beim Prägen bzw. bei der Trennung von zwei nacheinander geprägten Substraten geringstmöglich voneinander abweichen. Mit anderen Worten ist es möglich, dass die Vorspannung des Strukturstempels während des Präge- und/oder Trennvorganges sich ändert und eine geregelte variable Vorspannung verwendet wird. Dann bezieht sich das Minimum der Abweichung der Vorspannung auf die Widerholbarkeit der identischen Verfahrensschritte. Also kann die mechanische Spannung eines geprägten Substrats mit der mechanischen Spannung eines weiteren geprägten Substrats mit möglichst geringem Widerholungsfehler durchgeführt werden.

Analoges gilt für die möglichst konstant gehaltene mechanische Spannung bei der Trennung des geprägten Substrats vom Strukturstempel.

Der Fehler der mechanischen Spannung ist kleiner als 10%, bevorzugt kleiner als 5%, besonders bevorzugt kleiner als 2%, bezogen auf den Sollwert, insbesondere den Sollwert des jeweiligen Verfahrensschrittes.

Der Fehler der Dehnung (und daran gekoppelt die Maßhaltigkeit) des Strukturstempels ist kleiner als 100 ppm, bevorzugt kleiner als 10 ppm, besonders bevorzugt kleiner als 100 ppb, ganz besonders bevorzugt kleiner 10 ppb, im optimalen Fall kleiner als 5 ppb bezogen auf den Idealzustand der Maßhaltigkeit.

Das Prägen mit der Vorrichtung mit der Prägerolleneinheit, wobei die Vorspannung des Strukturstempels für eine konstante lokale Dehnung des Strukturstempels geregelt eingestellt wird, wird als ein eigenständiges Verfahren betrachtet.

### Weitere nicht erfindungsgemäße Vorrichtungen (semielastscher Strukturstempel ohne Prägerolle)

Eine dritte besonders bevorzugte Ausführungsform der Vorrichtung weist auf: zumindest eine Substrathalterung, einen abzuformenden Strukturstempel, Befestigungselemente für den Strukturstempel und eine Vorspanneinrichtung.

Ein mit Prägemasse beschichtetes Substrat ist für das Verfahren notwendig. Die Eigenschaften des beschriebenen Strukturstempels lassen sich auf die Strukturstempel mit Prägerolle entsprechend übertragen. Der Strukturstempel besteht aus mindestens zwei Bereichen, welche eine funktionale Unterteilung des Strukturstempels ermöglichen:
Es gibt einen Abformbereich, bevorzugt symmetrisch etwa um die Hälfte der charakteristischen Länge des Strukturstempels angeordnet, und einen Haltebereich, bevorzugt mindestens an zwei Enden des Strukturstempels ausgebildet.

Der Abformbereich des Strukturstempels ist bevorzugt formkongruent zum Substrat ausgebildet. Der Haltebereich des Strukturstempels umgibt den Abformbereich mindestens an zwei Seiten.

Der Abformbereich beinhaltet auf der Stempelseite die abzuformende, strukturierte Oberfläche des Strukturstempels. Der Abformbereich kann Ausrichtungsmarken, Versionsnummern, Steuerzeichen für die Positionierungsvorrichtung (Aligner) und/oder eine Belichtungsvorrichtung als Binär-Code oder als QR-Code beinhalten, wobei die Steuerzeichen oder die Ausrichtungsmarken nicht in der Prägemasse abgebildet werden müssen. In weiteren Ausführungsformen des Strukturstempels können die Ausrichtungsmarken, Versionsnummern, Steuerzeichen für die Positionierungsvorrichtung (Aligner) und/oder die Belichtungsvorrichtung auf der zur Stempelseite gegenüberliegenden Seite insbesondere nicht veränderbar aufgebracht werden.

Der Abformbereich ist bevorzugt zumindest optisch homogen und blasenfrei und fremdschattenfrei, mechanisch isotrop ausgebildet. Falls der Strukturstempel einen Träger beinhaltet, beziehen sich die Eigenschaften des Strukturstempels ebenfalls auf dem Träger. Der Träger besitzt bevorzugt eine homogene Dicke.

In einer weiteren Ausführungsform des Strukturstempels ist der Abformbereich so ausgelegt, dass eine gezielte Strukturierung des Trägers oder des Strukturstempels zusätzlich zu den abzuformenden Strukturen des Strukturstempels zur Minimierung und/oder Homogenisierung einer Restschichtdicke der geprägten Strukturen auf dem Substrat beiträgt. Bevorzugt wird eine Variation der Restschichtdicke unter 50 Nanometer, besonders bevorzugt unter 10 Nanometer, ganz besonders bevorzugt unter 1 Nanometer erzeugt.

Mit anderen Worten ist die strukturabhängige Restschichtdicke der geprägten Strukturen einstellbar.

Bei Anwendungen mit Abtragungsverfahren nach dem Prägen wird generell eine minimierte Restschichtdicke bevorzugt.

Für optische Anwendungen, insbesondere Diffraktivoptiken, Wellenleitern (engl. Diffractive optical elements, DOE) ist eine definierte, einstellbare, maßhaltende Restschichtdicke bevorzugt.

Es ist leicht einsehbar, dass eine Restschichtdicke bei Strukturgrößen in Größenordnung von Millimeter absolut größer ausfallen kann als bei Strukturgrößen in Größenordnung von Nanometern.

Die Grenze zwischen dem Haltebereich und dem Abformbereich ist in bevorzugten Ausführungsformen des Strukturstempels nicht als eine definierte Linie ausgebildet, sondern ist als Gebiet mit ineinander greifenden Funktionen zu verstehen.

Der Haltebereich erfüllt als Hauptaufgabe die Halterung des Strukturstempels in der Vorrichtung. Der Haltebereich kann dieselbe Materialeigenschaften wie der Abformbereich besitzen, kann jedoch in Form und/oder in Dicke und/oder Zusatzfunktionen und/oder Steifigkeiten und/oder Informationsgehalt davon abweichen.

In einer ersten Ausführungsform ist der Haltebereich die materielle Fortsetzung des Abformbereichs mit zumindest nahezu gleicher Dicke und Steifigkeit.

In einer zweiten Ausführungsform ist der Haltebereich eine materielle Fortsetzung des Abformbereichs mit einer veränderten Dicke des Abformbereichs und entsprechend geänderter Steifigkeit. Diese Ausführungsform ist insbesondere symmetrisch halbkeil- oder keilförmig ausgebildet, sodass der Strukturstempel möglichst kerbspannungsfrei auf einstellbarer Materialspannung vorgespannt werden kann.

In einer dritten Ausführungsform ist der Haltebereich eine materielle Fortsetzung des Abformbereichs mit ausgebildeten Feststoffgelenken.

Eine vierte Ausführungsform des Haltebereichs kann eine Kombination der zweiten und dritten Ausführungsform des Haltebereichs ergeben: Der Haltebereich beinhaltet Feststoffgelenke und keilförmige Elemente zur Befestigung des Strukturstempels in der Vorrichtung.

Eine fünfte Ausführungsform des Haltebereichs ist keilförmig unsymmetrisch im Querschnitt ausgebildet. Der Haltebereich besitzt auf der Prägeseite zumindest zwei ebene Ablageflächen. Die insbesondere eben ausgebildete Ablageflächen sind im Bezug zur Abformfläche des Strukturstempels abgesetzt, sodass der Abformbereich des Strukturstempels bei freier Lagerung in eine Gravitationsrichtung zeigend nicht mit einer Auflagefläche, auf welcher die Ablagefläche aufliegt, in Berührung kommt. Mit anderen Worten liegt der Strukturstempel am Rand auf einer Ablagefläche auf und die Prägeseite kommt mit der Ablagefläche nicht in Berührung und wird darüber mit der Eigensteifigkeit gehalten.

Die Steifigkeit des Haltebereichs und des Prägebereichs ist insbesondere derart ausreichend, dass der frei auf einer Auflagefläche, bevorzugt an beiden Enden des Stempels liegenden Auflageflächen, aufliegende Strukturstempel trotz Durchhängung als eine steife Platte mit dem Abformbereich die Auflagefläche nicht berührt.

Die Ablageflächen dienen dazu, den Strukturstempel außerhalb der Vorrichtung einfach, kontaminationsfrei lagern zu können. Weiterer Vorteil der Ausführungsform ist es, dass eine vorgegebene Richtung des Strukturstempels die Montagerichtung des Strukturstempels in der Vorrichtung vorgibt. Weitere Asymmetrien des Strukturstempels können dazu verwendet werden, eine ein-eindeutige Lage und Position des Strukturstempels in der Vorrichtung zu gewährleisten. Diese Maßnahmen setzen das Prinzip Schlüssel und Schloss um.

Eine Kombination der fünften Ausführungsform mit der zweiten und/oder dritten Ausführungsform wird als besonders vorteilhaft angesehen.

Die Befestigung des Strukturstempels in der Vorrichtung erfolgt insbesondere mit formschlüssigen Befestigungselementen. Zusätzlich zur Befestigungsfunktion werden die Befestigungselemente sowie der Strukturstempel zueinander korrespondierend weiter funktionalisiert. Insbesondere wird genau eine korrekte Einbaulage des Strukturstempels durch die Verwendung des Schlüssel-Schloss-Prinzips mit insbesondere asymmetrisch platzierten Formelementen oder asymmetrischer Ausbildung des Strukturstempels erreicht.

Die Auslegung eines Strukturstempels ist insbesondere das Resultat von Simulation und nummerischer Approximationen (finite Elementen Methode, FEM), wobei Parameter eines simulierten Prägeverfahrens zur Optimierung von Restschichtdicken der Prägemasse die Maßhaltigkeit und Lebensdauer des Strukturstempels beeinflussen. Wenn die Strukturstempeldicke inhomogen ausgebildet ist, wird die Steifigkeit sowie die optische Weglänge der Vernetzung, der Aushärtungsstrahlung oder der Wärmeübergang entsprechend der nummerischen Optimierung zweckmäßig ausgelegt. So können komplexe nachgiebige Gelenke für den Strukturstempel sowohl eine gleichmäßig konstante Vorspannung des Strukturstempels als auch nahezu verzerrungsfreie Prägestrukturen bewirken.

Es können somit insbesondere semielastische Strukturstempel entworfen, simuliert und hergestellt werden, wobei die Materialdehnung des Strukturstempels bevorzugt konstant gehalten wird und wobei mit entsprechend angepasster Materialdicke und/oder Materialsteifigkeit des Strukturstempels der Abformbereich des Strukturstempels eine höhere Ebenheit und/oder eine höhere Maßhaltigkeit beim Prägen behält als der Haltebereich. Insbesondere Festkörpergelenke aus dem Stempelmaterial/Trägermaterial des Strukturstempels ermöglichen eine Deformation des Strukturstempels zum Prägen mittels einer Krafteinwirkung des Strukturstempels. Der Strukturstempel kann insbesondere durch Krafteinwirkung bzw. ohne Krafteinwirkung zwei Formen annehmen, welche einen Ruhezustand des Strukturstempels bzw. eine vorgespannte, stabile Lage des Strukturstempels zum Prägen als Wirkung haben.

Der Strukturstempel wird bevorzugt so ausgelegt, dass die neutrale Faser des Strukturstempels dauerhaft auf der Prägeoberfläche bleibt. Die Abformungsoberfläche kann eine konstante Zugspannung erfahren, welche sich während des Prägevorgangs (ab Strukturherstellung des Strukturstempels) nicht verändert wird. Dazu kann die Vorrichtung entsprechend regelbar ausgeführt werden.

Damit wird erreicht, dass die zu übertragenden Prägestrukturen des Strukturstempels mechanisch spannungsfrei hergestellt sind und dadurch die größte variable Kraft die Trennkraft ist. Die Trennkraft wirkt näherungsweise normal auf die Prägestrukturen, sodass eine bessere Maßhaltigkeit der Prägestrukturen und des Strukturstempels erreicht wird.

Eine nicht erfindungsgemäße Vorrichtung nimmt den Strukturstempel in einen Stempelhalter mit translatorischen und rotatorischen Freiheitsgraden und Positioniersystemen auf. Der Strukturstempel und das mit Prägemasse beschichtete Substrat werden einander angenähert. Das Prägen wird durch Knicken des Strukturstempels durch die Zustellbewegungen der Positioniersysteme durchgeführt. Die Trennung des Strukturstempels nach der Aushärtung der Prägemasse erfolgt in einer Umkehr der Prägebewegung.

Mit anderen Worten kann die Abformarbeit des Strukturstempels aus der Biegebewegung resultieren, wobei bevorzugt keine externe Kraft auf die Rückseite der Stempeloberfläche außer der Gravitationskraft einwirkt. Dabei wird insbesondere die Abformungsoberfläche weniger als 20% der kritischen Strukturdimension, bevorzugt weniger als 5% der kritischen Strukturdimension, besonders bevorzugt weniger als 1%, ganz besonders bevorzugt weniger als 0,1% der kritischen Strukturdimension reversibel verformen, währenddessen der Haltebereich eine makroskopische Bewegung zum Prägen durchführt. Somit wird eine Knickbewegung des Strukturstempels zum Prägen verwendet. Die Urformarbeit des Prägens setzt sich aus der Prägekraft und aus dem zurückgelegten Weg zusammen. Die Wirkung der Kapillarkraft sowie die Biegebewegung des Strukturstempels als Resultierende werden die Urformarbeit verrichten.

Somit kann die Vorrichtung auf eine Trennvorrichtung sowie auf eine Prägerolle verzichten.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1: Schematische Strukturskizze einer ersten erfindungsgemäßen Ausführungsform einer erfindungsgemäßen Vorrichtung
- Fig. 2a: Schematische Strukturskizze einer zweiten nicht erfindungsgemäßen Vorrichtung in einer ersten Ausführungsform
- Fig. 2b: Schematische Strukturskizze einer zweiten nicht erfindungsgemäßen Vorrichtung in einer zweiten Ausführungsform
- Fig. 3: Schematische Strukturskizze einer weiteren Vorrichtung
- Fig. 4a: Schematische Strukturskizze eines Strukturstempels
- Fig. 4b: Schematische Strukturskizze der Anwendung des Strukturstempels nach Fig. 4a in einer nicht erfindungsgemäßen Vorrichtung
- Fig. 5: Schematische Strukturskizze der Anwendung des Strukturstempels nach Fig. 4b in einer nicht erfindungsgemäßen Vorrichtung
- Fig. 6: Schematische Strukturskizze einer dritten Ausführungsform eines Strukturstempels
- Fig. 7: Schematische Strukturskizze der Anwendung des Strukturstempels nach Fig. 6 in einer weiteren nicht erfindungsgemäßen Vorrichtung.

In den Figuren sind gleiche Bauteile oder Bauteile mit der gleichen Funktion mit den gleichen Bezugszeichen gekennzeichnet.

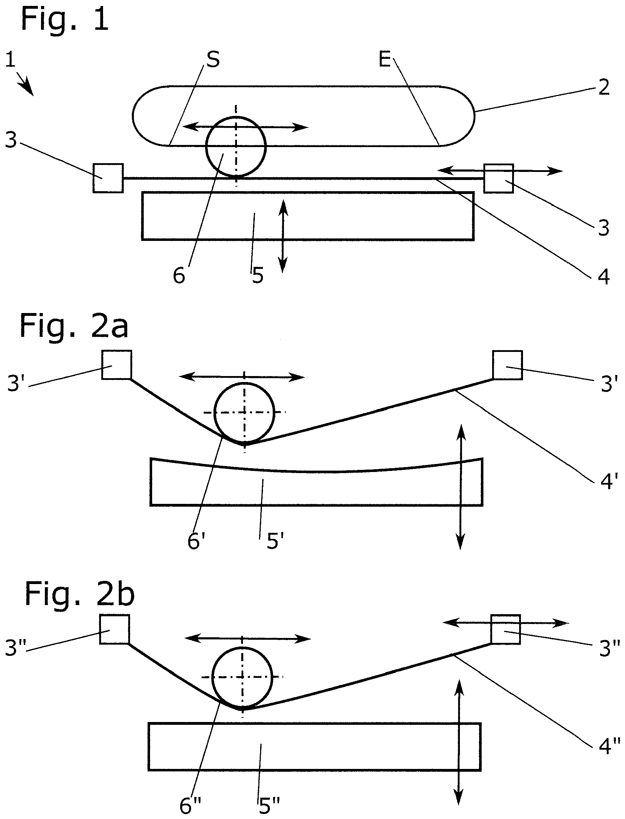

Fig. 1 stellt eine schematische Strukturskizze einer ersten erfindungsgemäßen Ausführungsform einer erfindungsgemäßen Vorrichtung 1 zum Prägen dar. Ein Strukturstempel 4 wird mittels Befestigungselementen 3 unter konstanter Dehnung gehalten. Die konstante, insbesondere einstellbare Dehnung des Strukturstempels ist mit dem Pfeil eines Befestigungselementes 3 angedeutet. Die Vorrichtung 1 stellt dazu eine insbesondere geregelte mechanische Kraft ein, welche als mechanische Spannung im Strukturstempel 4 eine konstante lokale Dehnung ermöglicht.

Ein nicht dargestelltes, mit Prägemasse beschichtetes Substrat wird auf einem Substrathalter 5 befestigt und der Strukturstempel 4 wird - nach Kontaktierung des Strukturstempels 4 mit der Prägemasse - in der Prägemasse abgeformt. Für eine ausreichende Urformarbeit drückt eine Prägerolle 6 den Strukturstempel 4 in die Prägemasse.

Für die Trennung des Strukturstempels 4 vom Substrat wird die Trennvorrichtung 2, hier als eine Bahn dargestellt, verwendet.

Die Trennvorrichtung 2 ist mit der Prägebahn zwischen einer Startposition S und einer Endposition E strukturell-materiell verbunden. Befindet sich die Prägerolle 6 auf der Strecke zwischen S und E wird der Strukturstempel 4 abgeformt, es wird geprägt. Befindet sich die Prägerolle 6 zwischen E und S außerhalb der Prägebahn auf der Trennbahn, nehmen nicht dargestellte Mitnehmer den Strukturstempel 4 entsprechend mit, damit der Strukturstempel 4 vom Substrat getrennt werden kann.

Insbesondere zur Unterstützung des Trennvorgangs kann der Substrathalter 5 ebenfalls bewegt werden. Die optionale Relativbewegung wird mit dem Pfeil angedeutet. Fig. 2a zeigt eine schematische Strukturskizze einer zweiten

Vorrichtung in einer ersten Ausführungsform. Ein Strukturstempel 4' wird mittels Befestigungselementen 3' in der nicht dargestellten Vorrichtung zum Prägen bevorzugt ortsfest befestigt. Eine Prägerolle 6` spannt den Strukturstempel 4' unter konstanter Dehnung vor, sodass der Strukturstempel 4` das nicht dargestellte, mit Prägemasse beschichtete Substrat prägen kann. Das Substrat wird auf einem Substrathalter 5' befestigt. Der Substrathalter 5' ist zustellbar, insbesondere geregelt zustellbar. Dies kann zur Einstellung der Prägekraft sowie zur Einstellung der Normalkraft bei der Trennung des Strukturstempels 4' vom Substrat verwendet werden. In weiteren Ausführungsformen ist der Substrathalter 5' nicht zustellbar, sodass die weitere Zustellbewegungen vom Strukturstempel, Befestigungselementen etc. durchgeführt werden.

Insbesondere eignet sich die gezeigte Ausführungsform zum Prägen von gekrümmten, bevorzugt elliptischen Substratoberflächen. Dies wird mit der Krümmung des Substrathalters 5' symbolisch dargestellt.

Fig. 2b zeigt eine schematische Strukturskizze der zweiten Vorrichtung in einer zweiten Ausführungsform. Ein Strukturstempel 4" wird mittels Befestigungselementen 3" in der nicht dargestellten Vorrichtung zum Prägen befestigt. Die Befestigungselemente 3" sind mit nicht dargestellten Bewegungs- und Messvorrichtungen gekoppelt, sodass die lokale Dehnung des Strukturstempels 4" auf die Wirkung einer Prägerolle 6" konstant gehalten werden kann und der Ellipsenfehler der Ausführungsform der Fig. 2a korrigiert werden kann. Die Prägerolle 6" spannt den Strukturstempel 4" unter konstanter Dehnung mit geregelter Spannung vor, sodass der Strukturstempel 4" das nicht dargestellte, mit Prägemasse beschichtetes Substrat prägen kann. Das Substrat wird auf einem zustellbaren, insbesondere geregelt zustellbaren Substrathalter 5" befestigt. In anderen Ausführungsformen wird die Zustellbewegung zum ortsfesten Substrathalter als Relativbewegung ausgeführt.

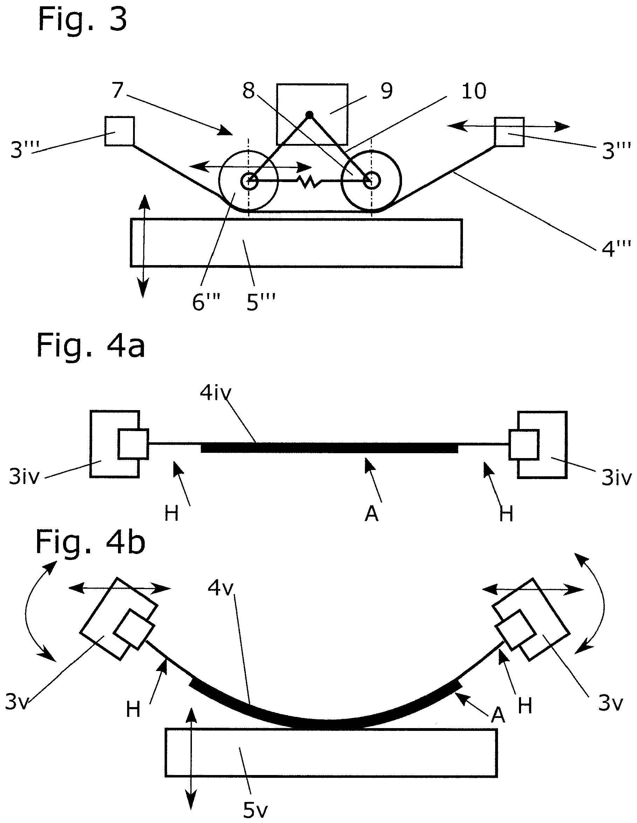

Fig. 3 zeigt eine schematische Strukturskizze einer Prägerolleneinheit 7 und Teile einer nicht dargestellten Vorrichtung. In einem Bewegungs-, Justierungs- und Führungseinheit 10 werden eine Prägerolle 6‴, eine Stützrolle 8 insbesondere durch die nicht dargestellte Regelung regelbar eingebaut. Weiterhin beinhaltet die Prägerolleneinheit 7 eine, bevorzugt zwischen der Prägerolle 6‴ und der Stützrolle 8 positionierte, Strahlungsquelle 9 zur Aushärtung der Prägemasse. Insbesondere in dem Spalt zwischen der Prägerolle 6‴ und der Stützrolle 8 erreicht die Strahlung der Strahlungsquelle 9 durch den insbesondere unter konstanter Dehnung einstellbar vorgespannten Strukturstempel 4‴ die nicht eingezeichnete, strukturierte Prägemasse. Das nicht eingezeichnete Substrat wird auf einem Substrathalter 5‴ befestigt, wobei der Substrathalter 5‴ geregelt zustellbar ausgebildet sein kann.

Bei einer weiteren Ausführungsform der Prägerolleneinheit 7 kann die Vorspannung des Strukturstempels 4‴ durch eine insbesondere geregelte Abstandsänderung zwischen der Prägerolle 6‴ und der Stützrolle 8 eingestellt werden. Mit anderen Worten spannen die Prägerolle 6‴ und die Stützrolle 8 den Strukturstempel 4‴ auf einer variablen Fläche zumindest angenähert eben auf. Dadurch kann der Ellipsenfehler der Vorrichtungen aus Fig. 1, 2a, 2b zusätzlich korrigiert werden und eine bessere Maßhaltigkeit bewirken.

Fig. 4a zeigt eine schematische Strukturskizze eines Strukturstempels 4iv mit integrierten Befestigungselementen 3iv, wobei ein Abformbereich A sowie ein Haltebereich H mit entsprechenden Funktionalitäten gekennzeichnet sind. Der Strukturstempel 4iv beinhaltet im Haltebereich H für eine formschlüssige Befestigung des Strukturstempels 4iv einen entsprechend dem Schloss-Schlüssel-Prinzip ausgebildeten Randbereich. Insbesondere kann die nicht dargestellte Vorrichtung die Befestigungselemente 3iv zwangfrei klemmen, sodass der Strukturstempel 4iv mit konstanter Vorspannung bei allen Verfahrensschritten belastet wird.

Fig. 4b zeigt eine schematische Strukturskizze eines Strukturstempels 4v mit integrierten Befestigungselementen 3v in einer nicht dargestellten Vorrichtung, wobei der Strukturstempel 4v insbesondere geregelt unter konstanter Dehnung verbleibt. Ein nicht dargestelltes Substrat wird auf einem zustellbaren Substrathalter 5v befestigt. Die relative Bewegung des Strukturstempels 4v mit dem Abformbereich A und dem Substrathalter 5v stellen den Kontakt des Strukturstempels 4v mit der Prägemasse her, sodass der Strukturstempel 4y in der Prägemasse abgeformt wird. Die integrierten Befestigungselemente 3v können den Strukturstempel 4v insbesondere frei von parasitären Kräften, bevorzugt zwangfrei, besonders bevorzugt nach dem Schlüssel-Schloss-Prinzip in der Vorrichtung befestigen. In weiteren Ausführungsformen kann der Substrathalter 5v ortsfest sein, die weiteren benötigten Bewegungen führt die Vorrichtung mit dem Strukturstempel aus.

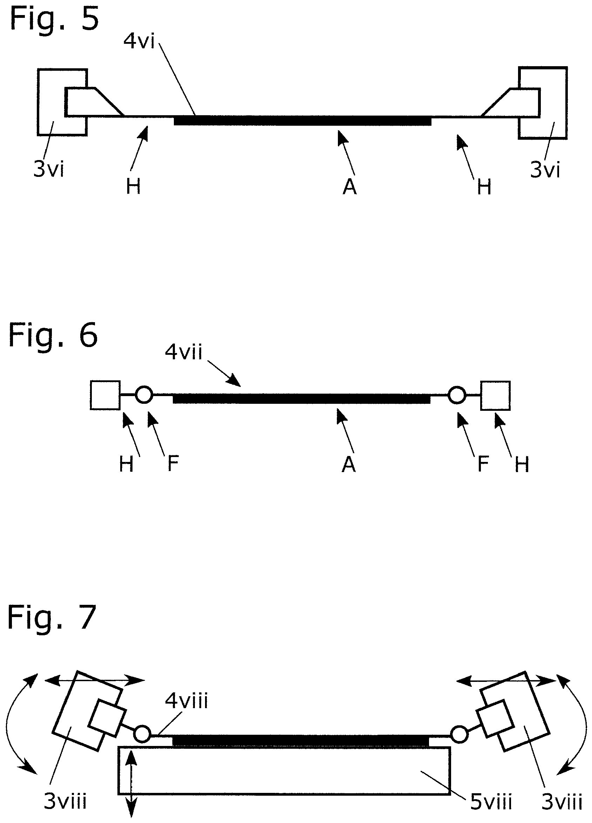

Fig. 5 zeigt eine schematische Strukturskizze einer weiteren Ausführungsform eines Strukturstempels 4vi mit integrierten Befestigungselementen 3vi. Um weitestgehend einen sprunghaften Übergang der Materialspannung im Strukturstempel 4vi zu vermeiden, wird im Halteberich des Strukturstempels 4vi ein zumindest halbkeilförmig, bevorzugt (nicht dargestellt) keilförmig, ausgebildeter Randbereich erzeugt. Hierdurch wird vorteilhaft eine kerbspannungsfreie Ausführungsform erreicht.

Eine vorteilhafte Ausführungsform kann durch eine doppelt asymmetrische Ausbildung des Strukturstempels 4vi erreicht werden. Bevorzugt wird eine Asymmetrie des Strukturstempels 4vi ausgenutzt, um insbesondere eine Einbaulage oben und unten durch konstruktive Merkmale unterscheiden zu können und einen fehlerhaften, seitenverkehrten Einbau in die Vorrichtung zu vermeiden.

Eine weitere Asymmetrie des Strukturstempels 4vi kann eine weitere, insbesondere ebene Koordinatenrichtung, "rechts-links" so kennzeichnen, dass eine seitenverkehrte Einbaulage des Strukturstempels gesperrt wird.

Diese Ausführungsform der doppelt asymmetrischen Bauweise des Strukturstempels 4vi kann bei allen erfindungsmäßigen Strukturstempeln angewendet werden. Eine asymmetrische Bauweise oder eine doppelt asymmetrische Bauweise aller Strukturstempel kann eine Anwendung des Prinzips Schlüssel-Schloss realisieren.

Fig. 6 zeigt eine schematische Strukturskizze einer dritten Ausführungsform eines Strukturstempels 4vii. Die Ausführungsform ist ähnlich zu den in Fig. 4a und Fig. 5 dargestellten Ausführungsformen. Der Strukturstempel 4vii besitzt bevorzugt materiell integrierte Festkörpergelenke F. Somit kann der Strukturstempel 4vii unterschiedliche Festigkeiten aufweisen, dabei jedoch einen ebenen Abformbereich aufweisen, insbesondere für rollenlose Prägevorgänge.

Fig. 7 zeigt eine schematische Strukturskizze einer dritten Ausführungsform eines Strukturstempels gemäß Fig. 6 als Teil einer nicht dargestellten Vorrichtung. Die nicht dargestellte Vorrichtung kann mittels geregelt positionierbaren und bewegbaren Befestigungselementen 3viii den Strukturstempel 4viii unter konstanter Dehnung insbesondere mit variabel geregelter Vorspannung in einer nicht dargestellten Prägemasse eines Substrats abformen. Ein Substrathalter 5viii kann das Substrat befestigen und geregelt bewegen.

In anderen Ausführungsformen wird ein ortsfester Substrathalter 5viii verwendet und die Relativbewegung zwischen Substratstempel 4viii und des Substrats wird vom Substratstempel durchgeführt.

Der Strukturstempel 4viii kann mittels unterschiedlichen Festigkeiten sowie Festkörpergelenke einen weitgehend ebenen Abformbereich ausbilden, wobei der Prägevorgang bevorzugt ohne Prägerolle, durch Knickung der Festkörpergelenke F des Strukturstempels (s. dazu Fig. 6) eingeleitet werden kann.

### Bezugszeichenliste

1 Vorrichtung zum Prägen
2 Trennvorrichtung
3, 3', 3", 3‴, 3iv, 3v, 3vi, 3viii Befestigungselement für den Strukturstempel
4, 4',4", 4‴, 4iv, 4v, 4vi, 4vii, 4viii Strukturstempel
5, 5',5",5‴,5v, 5viii Substrathalter
6, 6',6",6‴ Prägerolle
7 Prägerolleneinheit
8 Stützrolle
9 Strahlungsquelle
10 Bewegungs-, Justierungs- und Führungseinheit S Startposition
E Endposition
H Haltebereich
A Abformbereich
F Festkörpergelenk

## Patentansprüche

1. Vorrichtung (1) zum Prägen von Strukturen in eine Prägemasse, aufweisend einen Strukturstempel (4) zum Prägen der Strukturen in die Prägemasse und eine Prägerolle (6) zum Drücken der Strukturen des Strukturstempels in die Prägemasse, wobei der Strukturstempel während des Prägens und des Trennens von der Prägemasse unter einer konstanten lokalen Dehnung haltbar ist, **dadurch gekennzeichnet, dass** Prägerolle Mitnehmer zum Abheben des Strukturstempels nach dem Prägen aufweist.

2. Vorrichtung (1) nach Anspruch I, wobei die Prägerolle mit dem Strukturstempel nach dem Prägen von einer Endposition (E) auf einer Trennbahn (2) zurück zu einem Startpunkt (S) einer erneuten Prägung beweglich ist.

3. Verfahren zum Prägen von Strukturen in eine Prägemasse, wobei ein Strukturstempel (4) die Strukturen in die Prägemasse prägt, wobei der Strukturstempel während des Prägens und des Trennens von der Prägemasse unter einer konstanten lokalen Dehnung gehalten wird, und wobei eine Prägerolle (6) zum Drücken der Strukturen des Strukturstempels in die Prägemasse benutzt wird, **dadurch gekennzeichnet, dass** die Prägerolle Mitnehmer zum Abheben des Strukturstempels nach dem Prägen aufweist.

## Claims

1. A device (1) for embossing substrates in an embossing compound, comprising a structured stamp (4) for embossing the structures into the embossing compound and an embossing roller (6) for pressing the structures of the structured stamp into the embossing compound, wherein the structured stamp can be kept under a constant local extension during the embossing of and the separation from the embossing compound,
**characterised in that** the embossing roller comprises a driver for lifting the structured stamp after the embossing.

2. The device (1) according to claim 1, wherein the embossing roller with the structured stamp can be moved after the embossing from an end position (E) on a separating track (2) back to a starting point (S) of a renewed embossing.

3. A method for embossing structures into an embossing compound, wherein the structured stamp (4) embosses the structures into the embossing compound, wherein the structured stamp is held under a constant local extension during the embossing of and separation from the embossing compound, and wherein an embossing roller (6) is used for pressing the structures of the structured stamp into the embossing compound, **characterised in that** the embossing roller comprises a driver for lifting the structured stamp after the embossing.

## Revendications

1. Dispositif (1) pour marquer des structures dans une masse à marquer, présentant un poinçon de structure (4) pour marquer les structures dans la masse à marquer, et un rouleau à marquer (6) pour appuyer les structures du poinçon de structure dans la masse à marquer,
dans lequel le poinçon de structure peut être maintenu à une dilatation locale constante pendant le marquage et la séparation de la masse à marquer,
**caractérisé en ce que** le rouleau à marquer présente des entraîneurs pour enlever le poinçon de structure après le marquage.

2. Dispositif (1) selon la revendication 1, dans lequel, après le marquage, le rouleau à marquer avec le poinçon de structure peut être renvoyé d'une position de bout de course (E) sur un lé de séparation (2) vers un point de départ (S) d'un nouveau marquage.

3. Procédé de marquage de structures dans une masse à marquer, dans lequel un poinçon de structure (4) marque les structures dans la masse à marquer, dans lequel le poinçon de structure est maintenu à une dilatation locale constante pendant le marquage et la séparation de la masse à marquer,
et dans lequel un rouleau à marquer (6) est utilisé pour appuyer les structures du poinçon de structure dans la masse à marquer, **caractérisé en ce que** le rouleau à marquer présente des entraîneurs pour enlever le poinçon de structure après le marquage.
